# EUROPEAN PATENT SPECIFICATION

(11) **EP 3 849 294 B1**
(45) Date of publication and mention of the grant of the patent: **10.08.2022**
(21) Application number: 19913563.3
(22) Date of filing: 05.06.2019
(51) Int. Cl.: H05K 7/20

(54) **COOLING-HEAT DISSIPATING CASE AND HEAT DISSIPATION CONTROL METHOD**
KÜHLWÄRMEABLEITENDES GEHÄUSE UND WÄRMEABLEITUNGSTEUERUNGSVERFAHREN
BOÎTIER DE DISSIPATION THERMIQUE DE REFROIDISSEMENT ET PROCÉDÉ DE COMMANDE DE DISSIPATION THERMIQUE

(30) Priority: 03.04.2019 CN 201910266650
(43) Date of publication of application: 14.07.2021
(73) Proprietor: CRRC QINGDAO SIFANG ROLLING STOCK RESEARCH INSTITUTE CO., LTD., Shibei District Qingdao Shandong 266000 (CN)
(72) Inventor: LI, Zuoxin, Qingdao, Shandong 266000 (CN); LIN, Xiangli, Qingdao, Shandong 266000 (CN); HAN, Yansong, Qingdao, Shandong 266000 (CN); LI, Changfan, Qingdao, Shandong 266000 (CN); ZHU, Youyuan, Qingdao, Shandong 266000 (CN); CHI, Jiuming, Qingdao, Shandong 266000 (CN); PENG, Jian, Qingdao, Shandong 266000 (CN); WANG, Fei, Qingdao, Shandong 266000 (CN); LIU, Yingying, Qingdao, Shandong 266000 (CN); HAN, Xi, Qingdao, Shandong 266000 (CN)
(74) Representative: J A Kemp LLP
(86) International application number: PCT/CN2019/090156
(87) International publication number: WO 2020/155502

(56) References cited:
- EP-A1- 0 794 098
- CN-A- 101 634 477
- CN-A- 105 699 946
- CN-A- 106 452 106
- US-A1- 2005 150 634
- US-A1- 2009 249 862
- US-B1- 6 250 083

## Description

### TECHNICAL FIELD

The present application relates to a cooling and heat radiating box of a charger used in a high-speed train and heat radiating control method therefor, and belongs to the field of heat radiation.

### BACKGROUND OF THE PRESENT INVENTION

A charger is composed of various electric elements such as power semiconductor, transformer, and inductor and so on. During working, the electric elements can continuously generate heat so that temperature of the elements will rise; and meanwhile, air in box can also be heated so that the temperature of the internal environment of the box will be raised.

With the development of a high-speed train technology, the design requirements of the charger are higher and higher, thus the charger gradually becomes smaller and integrated, but the power of the charger is unchanged and even increased. Both the decrease of space and the increase of the elements' intensiveness will result in continuous rise of working temperatures of the elements and the internal environmental temperature of the box. The working temperature rise of the elements greatly affects performances of the elements themselves, the rise of the environmental temperature also greatly affects non-heating elements such as internal sensors, capacitors and the like, and therefore, it is necessary to realize heat radiation of heating elements and the internal environment of the box. However, at present, the charger generally adopts natural cooling as a conventional heat radiation mode, the structure is relatively simple, and therefore, it can only meet heat radiation requirements of ordinary chargers.

EP0794098A1 disclosed an electric power transforming apparatus for an electric rolling stock, the apparatus comprises a power transformer including a plurality of switching elements for controlling an induction motor for driving the electric rolling stock, cooling device for cooling the power transformer, a heat receiving panel having the switching elements mounted thereon and a cooling liquid passageway formed inside, a heat exchanger for exchanging heat between the cooling liquid from the heat receiving panel and air, a pump for circulating the cooling liquid between the heat receiving panel and the heat exchanger, and blower for sending cooling air to the heat exchanger, wherein the heat receiving panel, the heat exchanger, the pump and the blower are installed under the floor of the electric rolling stock, the heat exchanger being disposed adjacent to one side of the electric rolling stock, the blower being arranged so that the cooling air is taken in from the other side of the rolling stock where the heat exchanger is not disposed and discharged from the one side where said heat exchanger is disposed.

### SUMMARY OF THE PRESENT INVENTION

The present application provides a cooling and heat radiating box and a heat radiating control method, which can be used for radiating heat of heating elements, especially suitable for the requirements of heat radiation of elements of a charger of a high-speed train and an internal environment of the box, so as to ensure that temperature of the elements themselves and the environmental temperature are in appropriate states.

The invention is set out in the appended set of claims.

### BRIEF DESCRIPTION OF THE DRAWINGS

Fig. 1 is a top view showing one implementation of the present application;
Fig. 2 is a cross-sectional view showing one implementation of the present application;
Fig. 3 is a longitudinal sectional view showing one implementation of the present application;
Fig. 4 is a view showing a structure of a second heat radiating fin in one implementation of the present application;
Fig. 5 is a top view showing a preferred embodiment covered by the claimed invention;
Fig. 6 is a cross-sectional view showing the preferred embodiment;
Fig. 7 is a sectional view of Fig. 5 taken along line A-A, that is, a longitudinal sectional view;
Fig. 8 is a sectional view of Fig. 5 taken along line B-B; and
Fig. 9 is a schematic diagram showing a connection relationship of a control unit; in which:
   1-first air passage chamber; 101-first end of the first air passage chamber; 102-second end of the first air passage chamber; 2-inner chamber; 201-element region; 202-cavity region; 3-air inlet; 4-first blower; 5-first blower chamber; 6-air outlet; 7-first partition plate; 8-first ventilating opening; 9-first ventilating path; 10-second air passage chamber; 11-second partition plate; 12-second ventilating opening; 13-third partition plate; 14-third ventilating opening; 15-second blower; 16-second ventilating path; 17-fourth partition plate; 18-fourth ventilating opening; 19-fifth partition plate; 20-first heat radiating fin; 21-sixth partition plate; 22-second heat radiating fin; 2201-first fin group; 2202-second fin group; 2203-connecting plate; 23-first temperature sensor; 24-second temperature sensor; 25-wiring chamber; 26-control unit.

### DETAILED DESCRIPTION OF THE EMBODIMENTS

The present application will be specifically described below in exemplary implementation modes. However, it should be understood that elements, structures and features in one implementation can also be beneficially combined into other implementations without further recitation.

In the description of the present application, it should be noted that direction or positional relationships indicated by terms such as "inner", "outer", "upper", "lower", "front" and "rear" are positional relationships based on the correspondent drawings, are merely intended to facilitate describing the present application and simplifying the description, rather than to indicate or imply that the appointed box or element has to be located in a specific direction or structured and operated in the specific direction so as not to be understood as restrictions on the present application. The connection can be a direct connection relationship or an indirect connection relationship when not being explicitly specified. In addition, terms such as "first", "second" and "third" and the like are merely for descriptive purposes, and cannot be understood as indicating or implying the relative importance.

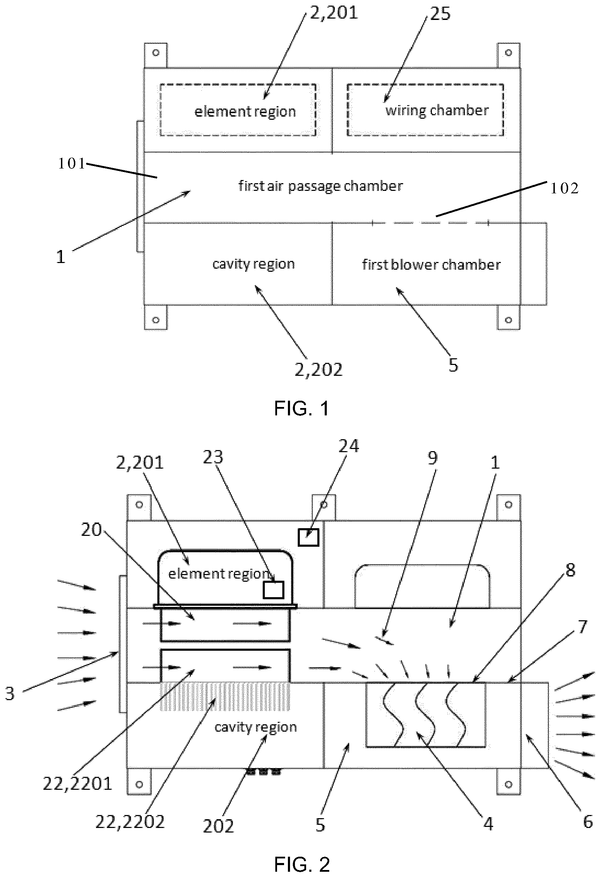

One implementation not covered by the claimed invention provides a cooling and heat radiating box, as shown in Fig. 1 to Fig. 3. In Fig. 1, in order to facilitate understanding, an upper surface structure is omitted, the box is provided with a first air passage chamber 1 and an inner chamber 2 surrounding the first air passage chamber 1, and the first air passage chamber 1 does not communicate with the inner chamber 2.

The inner chamber 2 comprises an element region 201 and a cavity region 202, and heating elements or ordinary elements are disposed in the element region 201. For example, for a charger, power modules of the charger can be disposed in the element region 201, the heating elements can be various power semiconductors, transformers, inductors and the like in the power modules, and the ordinary elements can be capacitors, sensors and the like in the power modules.

A first end 101 of the first air passage chamber is connected to an air inlet 3, a second end 102 of the first air passage chamber is connected to a first blower chamber 5 for mounting a first blower 4, and the first blower chamber 5 is provided with an air outlet 6. A first partition plate 7 located between the first air passage chamber 1 and the first blower chamber 5 is provided with one or a plurality of first ventilating opening(s) 8. The air inlet 3, the first air passage chamber 1, the first blower chamber 5 and the air outlet 6 form a first ventilating path 9 for realizing air flow in the first air passage chamber 1. The first air passage chamber 1 receives cooling air from the outside, and therefore, environmental conditions in the chamber are generally relatively poor. In order to avoid all elements in the inner chamber 2 from being polluted, a mode of isolating the first air passage chamber 1 from the inner chamber 2 is selected.

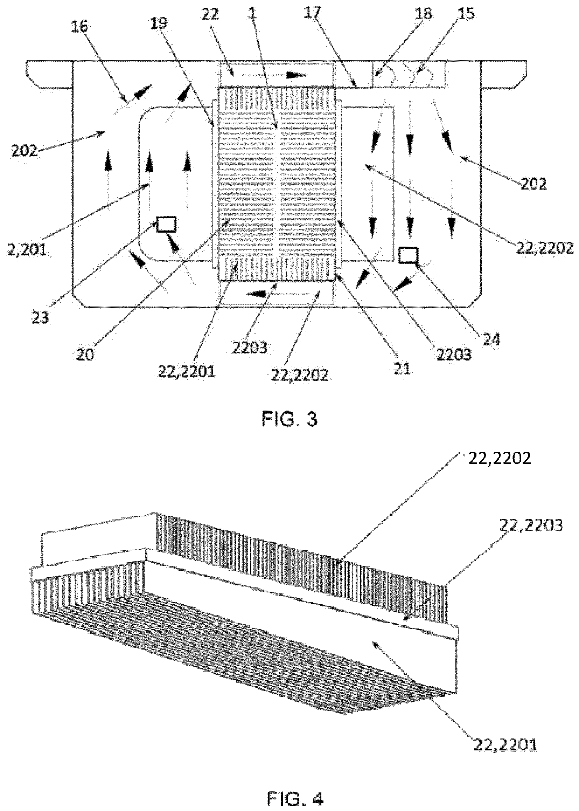

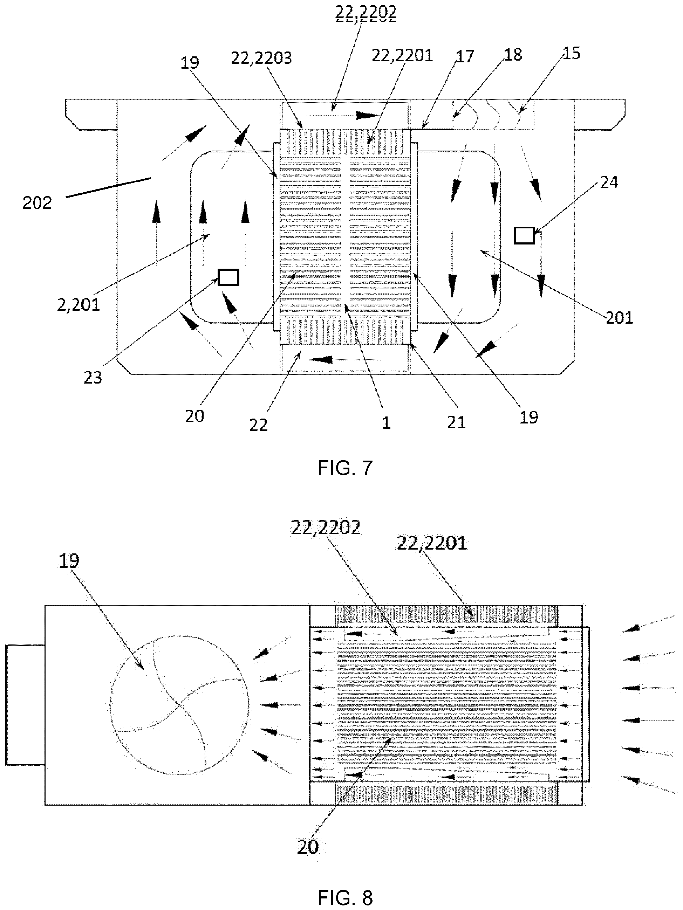

A second blower 15 is disposed in the inner chamber 2 and is preferably located in the cavity region 202, and the second blower 15 is used for enabling air in the inner chamber 2 to circularly flow to form a second ventilating path 16, as shown in Fig. 3 and Fig. 7.A fifth partition plate 19 located between the element region 201 and the first air passage chamber 1 is provided with a first heat radiating fin 20, the first heat radiating fin 20 is exposed in the first air passage chamber 1, and the temperature of the element region 201 can be lowered by exchanging heat with cold air in the first air passage chamber 1. Preferably, the element region 201 is directly disposed on the fifth partition plate 19, and thus, heat generated by the heating elements can be directly transferred in thermal conduction mode by the fifth partition plate 19 to the first heat radiation fin 20 for heat radiation.

A sixth partition plate 21 located between the cavity region 202 and the first air passage chamber 1 is provided with a second heat radiating fin 22, the second heat radiating fin 22 is exposed in the first air passage chamber 1, and the temperature of the cavity region 202 can be lowered by exchanging heat with cold air in the first air passage chamber 1. Heat in the inner chamber 2 can be partially radiated to the outside through the wall of the inner chamber regardless of whether the second heat radiating fin 22 is disposed in the cavity region, but the heat radiation effect is realtively limited. The second heat radiation fin 22 is disposed to enhance heat radiation in the inner chamber 2 and thus be more beneficial to the cooling of the heating elements.

As shown in Fig. 2 and Fig. 3, a first temperature sensor 23 capable of detecting temperature of the heating elements is disposed in the inner chamber 2, for example, the first temperature sensor 23 can be fixedly disposed on the surfaces of the heating elements. A second temperature sensor 24 capable of detecting air temperature of the inner chamber 2 is further disposed in the inner chamber 2, preferably, the second temperature sensor 24 is disposed in the cavity region 202. The second temperature sensor 24 can be selected to be far enough, such as greater than or equal to 100 mm, from the heating elements, so that the temeprature rise of the air in the inner chamber 2 is monitored in real time without repeatedly monitoring the temperature of the surfaces of the heating elements.

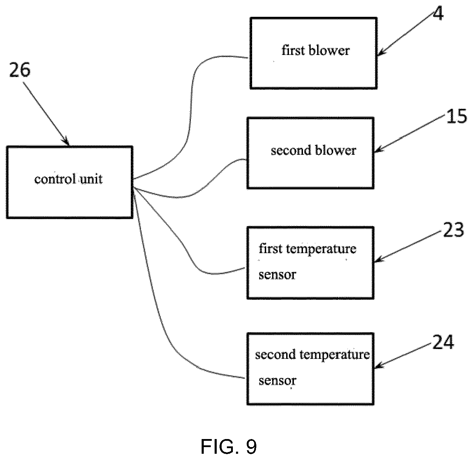

The box is further provided with a control unit 26, and the control unit 26 is electrically connected with the first blower 4, the second blower 15, the first temperature sensor 23 and the second temperature sensor 24, as shown in Fig. 9.

The control unit 26 is used for controlling the first blower 4 and the second blower 15 to be started or stopped by receiving temperature information acquired by the temperature sensors (23, 24).

As a preferred implementation, the first blower 4 can adopt a multi-position blower so that the ventilation rate of the first ventilating path 9 may be adjusted according to a heat radiation requirement.

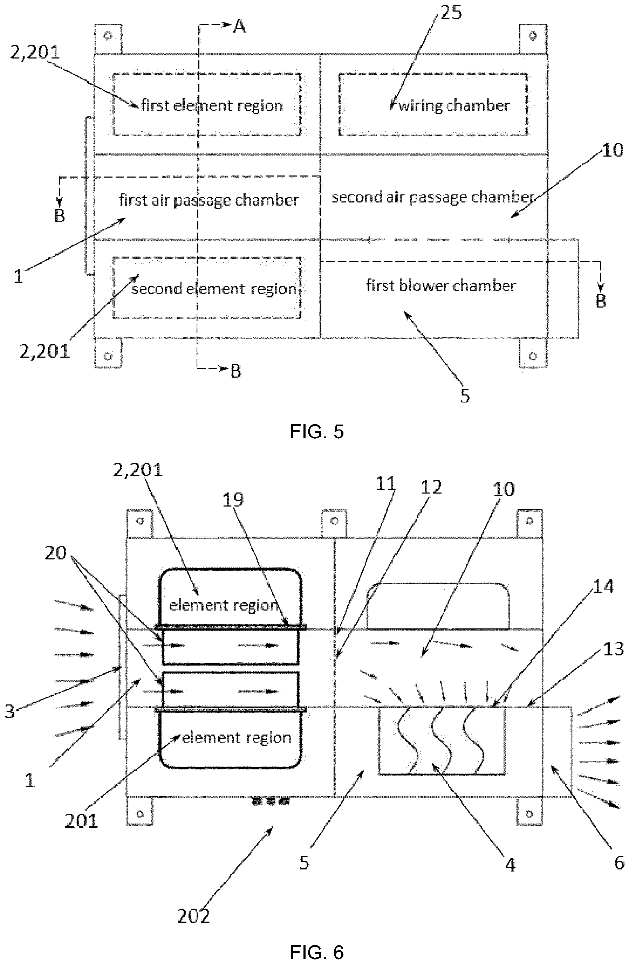

As a preferred implementation, as shown in Fig. 5 and Fig. 6, a second air passage chamber 10 can also be disposed between the first air passage chamber 1 and the first blower chamber 5. A second partition plate 11 located between the first air passage chamber 1 and the second air passage chamber 10 is provided with one or a plurality of second ventilating opening(s) 12, and air circulation is realized through the second ventilating opening(s) 12. A third partition plate 13 located between the second air passage chamber 10 and the first blower chamber 5 is provided with one or a plurality of third ventilating opening(s) 14, and air circulation is realized through the third ventilating opening(s) 14. By disposing the second air passage chamber 10, air from the first air passage chamber 1 can be firstly buffered in the second air passage chamber 10, then enter the first blower chamber 5 after being dispersed and be extracted by the first blower 4. Such dispersion is beneficial to the uniform distribution of the air in the first air passage chamber 1 without making thermal exchange area oversmall. Seen by comparing air flow line in Fig. 2 and Fig. 6, a mode that adopt disposing the second air passage chamber 10 is more beneficial to the uniformity of air in the first air passage chamber 1.

As a preferred implementation, a mounting position of the element region 201 in the inner chamber 2 is close to an air flow incoming direction in the first air passage chamber 1, that is, close to the air inlet 3. In particular, preferably, the heating elements is mounted at a position close to the air inlet 3, so that the heating elements are cooled by an optimal temperature difference, the space of cooling air passage of the box and the cooling air flow at the air inlet are sufficiently utilized, and an effect of synchronous heat radiating inside and outside the box is achieved.

As a preferred implementation, a fourth partition plate 17 is disposed in the inner chamber, a fourth ventilating opening 18 is arranged at the fourth partition plate 17, and the second blower 15 is disposed at the fourth ventilating opening 18 and is used for transporting air at one side of the fourth partition plate to another side, thereby realizing air circulation in the element region 201 and the cavity region 202. By using the second blower 15, the forced circulation of the inner chamber 2 can be realized, thus the over high temperature in the local region can be avoided to affect the working performances of the elements.

As a preferred implementation, the second heat radiating fin 22 is a bidirectional heat radiating fin, a first fin group 2201 of the second heat radiating fin 22 at a first side of the second heat radiating fin 22 is exposed in the first air passage chamber 1, and a second fin group 2202 of the second heat radiating fin 22 at a second side of the second heat radiating fin 22 is exposed in the cavity region 202. Specifically, the second heat radiating fin 22 has a structure as shown in Fig. 4, the second heat radiating fin 22 comprises a first fin group 2201 and a second fin group 2202, each of the fin groups includes a plurality of fins disposed in parallel, a connecting plate 2203 for mounting the fins is disposed between the two fin groups, and the connecting plate 2203 can be used as a part of the sixth partition plate 21.

As a preferred implementation, as shown in Fig. 4 and Fig. 8, fins of the first fin group 2201 are gradually raised along an air flowing direction. The effect of the fins lies in realizing the distribution of cooling air flow among the fins, the problem of heat radiation efficiency inconsistence that low air temperature at the air inlet and high air temperature at the air outlet caused by overlarge fin length is solved, so as to realize the balance of the front and rear heat radiation of the heat radiating fin.

As a preferred implementation, as shown in Fig. 2 and Fig. 3, the first heat radiating fin 20 and the first fin group 2201 which are exposed in the first air passage chamber 1 are disposed in a direction the same as an air flowing direction in the first air passage chamber 1, approximately, parallel to the air flowing direction in the first air passage chamber 1.

As a preferred implementation, as shown in Fig. 3 and Fig. 8, the second fin group 2202 of the second heat radiating fin exposed in the inner chamber 2 is disposed in a direction the same as an air flowing direction in the inner chamber 2, approximately, parallel to the air flowing direction in the inner chamber 2. Preferably, the first fin group 2201 and the second fin group 2202 are disposed to be perpendicular to each other.

When the heat radiating fins are mounted between the inner chamber 2 and the first air passage chamber 1, isolation between the inner chamber 2 and the first air passage chamber 1 can be realized in a way such as disposing a plurality of sealing strips, thereby guaranteeing the protection level inside the box.

When the first blower 4 works, external cold air is sucked by the first blower 4 into the first air passage chamber 1 through the air inlet 3 and is subjected to thermal convection with the first heat radiating fin 20 and the second heat radiating fin 22 in the first air passage chamber 1, then, the external cold air enters the second air passage chamber 10 and then enters the first blower chamber 5, and the first blower 4 works to take heat out of the box through the air outlet 6, so that the inside of the box is cooled.

For the heat in the inner chamber 2, on one hand, heat of the heating elements is transferred to the first heat radiating fin 20 by thermal conduction, and the thermal exchange is realized by the first heat radiating fin 20 and the air in the first air passage chamber 1; and on the other hand, under the action of the second blower 15, high-temperature air surrounding the element region 201 is transferred to the second heat radiating fin 22 by thermal convection under the function of internal circulation and is subjected to thermal exchange with the air in the first air passage chamber 1.

Specifically, the first temperature sensor 23 is used for acquiring the temperature of the heating elements in real time, and transmitting acquired first temperature to the control unit 26;
the control unit 26 is configured to compare the first temperature with a first threshold, and when the first temperature is equal to or greater than the first threshold, the control unit 26 controls the first blower 4 to be started to initiate ventilation and heat radiation in the first air passage chamber 1, so that the heating elements are cooled through the first heat radiating fin 20;
the second temperature sensor 24 is used for acquiring the air temperature of the inner chamber 2 in real time, and transmitting acquired second temperature to the control unit 26; and
the control unit 26 is configured to compare the second temperature with a second threshold, and when the second temperature is equal to or greater than the second threshold, the control unit 26 controls the second blower 15 to be started to initiate air circulation in the inner chamber 2. By using the second heat radiating fin 22, the heat radiation area in the inner chamber 2 is increased, so that heat in the element region 201 is radiated by thermal convection.

Further, as a preferred implementation mode, when the first temperature, acquired by the first temperature sensor 23, of the heating elements is equal to or greater than a third threshold, the control unit 26 is used for controlling the first blower 4 to rise position to increase the air flow rate in the first air passage chamber 1, thereby accelerating thermal exchange.

The control unit 26 can adopt a CPU, and the above-mentioned control function can be achieved in a programming mode. The CPU can be integrated in the box.

The first threshold, the second threshold and the third threshold are temperature values preset according to temperatures bearable for the heating elements or other elements and aim at protecting the normal operation of the elements, and therefore, the setting of the thresholds is related to the heating elements and the disposing positions and can be set by working staff according to actual requirements. For example, the first threshold is set as 65°C, the second threshold is set as 50°C, and the third threshold is set as 80°C. When the temperature of the heating elements is 50°C, the first temperature sensor 23 transmits acquired temperature information to the control unit 26, and there is no feedback from the control unit 26 at the moment.

When the temperature of the heating elements is equal to or greater than 65°C, the control unit 26 controls the first blower 4 to be started to work on a first position to radiate the heat of the heating elements. If the temperature of the heating elements is still very high or a great deal of heat is continuously radiated to make the air temperature induced by the second temperature sensor 24 in the inner chamber 2 greater than or equal to 50°C, at the moment, the control unit 26 controls the second blower 15 to be started to work and performs thermal exchange with the air in the first air passage chamber 1 at the second heat radiating fin 22 by thermal convection so that cooling is performed. If the temperature of the heating elements is still not lowered, when the temperatures acquired by the first temperature sensor 23 is equal to or greater than 80°C, the control unit 26 controls the first blower 4 to rise to a higher position, so that the flow rate of the heat-exchanged air is increased.

As a preferred embodiment covered by the claimed invention, as shown in Fig. 5 to Fig. 7, two sides of the first air passage chamber 1 are respectively provided with the element regions 201 which are symmetrically disposed; and the first heat radiating fin 20 is disposed between each of the element regions 201 and the first air passage chamber 1. In this way, the cavity region 202 is also divided into two parts shown as two cavity regions at upper and lower parts in Fig. 7. By disposing the two symmetric element regions, a centralized heat region can be divided into two parts, which is more beneficial to heat radiation; and meanwhile, the disposing of the second heat radiating fin 22 in the cavity region 202 is also not impeded.

In order to solve the heat radiation problem of the charger, the power modules of the charger can be respectively disposed in the two element regions according to a positional relationship for connections among the modules, and preferably, the heating elements such as various power semiconductors, transformers and inductors are mounted close to the air inlet 3, and ordinary elements such as capacitors and sensors are mounted close to the of the first blower.

As a preferred implementation, as shown in Fig. 1 and Fig. 5, a wiring chamber 25 can also be disposed in the box, and the wiring chamber 25 is respectively adjacent to the inner chamber 2 and the second air passage chamber 10. The wiring chamber 25 is used for placing external input wiring equipment and output wiring equipment of the box such as a terminal strip and a wiring terminal. The equipment can be connected with elements inside the box and can realize wire disconnection and connection.

A further embodiment covered by the claimed invention provides a heat radiating control method for a cooling and heat radiating box. The heat radiating control method can be implemented by adopting the forementioned cooling and heat radiating box and comprises the following steps:
(1) the first temperature sensor 23 acquires the temperatures of the heating elements in real time, and transmits acquired first temperature to the control unit 26; the control unit 26 compares the first temperature with a first threshold, and when the first temperature is equal to or greater than the first threshold, the control unit 26 controls the first blower 4 to be started to initiate ventilation and heat radiation in the first air passage chamber 1, so that the heating elements are cooled; and
(2) the second temperature sensor 24 acquires the air temperature of the inner chamber 2 in real time, and transmits acquired second temperature to the control unit 26;
   the control unit 26 compares the second temperature with a second threshold, and when the second temperature is equal to or greater than the second threshold, the control unit 26 controls the second blower 15 to be started to initiate air circulation in the inner chamber 2, so that heat of the inner chamber 2 is radiated through the second heat radiating fin 22.

As a preferred implementation mode, the control method further comprises: when the first temperature acquired by the first temperature sensor 23 is equal to or greater than a third threshold, the control unit 26 controls the first blower 4 to rise position to increase the air flowing rate in the first air passage chamber 1, thereby accelerating thermal exchange.

The present application further has the following advantages:
(1) in the present application, by disposing inner and outer heat radiation paths and the heat radiating fins, heat transfer between a circular air flow inside the box and an external air flow is realized, and the efficiency of heat radiation inside the box is increased. The heat radiating fins in the present application can be distributed in a mode of surrounding four surfaces at the upper, lower, left and right of the first air passage chamber, and thus, a cooling air flow flowing through the first air passage chamber is sufficiently utilized.
(2) The first blower and the second blower are controlled according to the temperature in the inner chamber and the temperature of the elements, so that the normal operation of the heating elements at working temperature is guaranteed, in addition, the energy consumption of the equipment itself is reduced.
(3) in the present application, the blowers are mounted on both the first ventilating path and the second ventilating path to force air to circulate. The first ventilating path forces the external cooling air flow to flow through the air passage chambers to form thermal convection with the first heat radiating fin and the first fin group, so that the temperature of the heat radiating fins are lowered, and requirements of the elements on heat radiation and working environments are guaranteed. The second ventilating path forces air to circulate to ensure that high-temperature air in the inner chamber flows through the second fin group, and heat of the internal air is transferred to the first fin group by thermal convection to cool the air inside the box, so that normal working environments of the elements inside the box are guaranteed.

## Claims

1. A cooling and heat radiating box of a charger used in a high-speed train, the cooling and heat radiating box comprising a first air passage chamber (1) and an inner chamber (2) surrounding the first air passage chamber;
a first end (101) of the first air passage chamber is connected to an air inlet (3), a second end (102) of the first air passage chamber communicates to a first blower chamber (5), and a first blower (4) is disposed inside the first blower chamber (5); the first blower chamber (5) is provided with an air outlet (6); and the air inlet (3), the first air passage chamber (1), the first blower chamber (5) and the air outlet (6) sequentially form a first ventilating path (9) for realizing air flow in the first air passage chamber;
the inner chamber (2) comprises element regions (201) and a cavity region (202), and heating elements are disposed in the element regions (201), wherein each of two sides of the first air passage chamber (1) is provided with one of the element regions (201) respectively; the cavity region (202) comprises the element regions (201), the cavity region (202) surrounds the whole first air passage chamber (1);
a second blower (15) is disposed in the inner chamber (2) and is used for enabling air in the inner chamber to flow to form a second ventilating path (16);
a first heat radiating fin (20) is disposed between each of the element regions (201) and the first air passage chamber (1), and the first heat radiating fin (20) is exposed in the first air passage chamber (1);
a second heat radiating fin (22) is disposed between the cavity region (202) and the first air passage chamber (1), and the second heat radiating fin (22) is exposed in the first air passage chamber (1); the second heat radiating fin (22) is provided both at an upper side and a lower side of the first air passage chamber (1);
both the first heat radiating fin (20) and the second heat radiating fin (22) are provided on opposite sides of the first passage chamber (1);
a first temperature sensor (23) capable of detecting temperature of the heating elements and a second temperature sensor (24) capable of detecting air temperature of the inner chamber are disposed in the inner chamber (2);
the box is further provided with a control unit (26), and the control unit (26) is electrically connected with the first blower (4), the second blower (15), the first temperature sensor (23) and the second temperature sensor (24); and the control unit (26) is used for controlling the first blower (4) and the second blower (15) to be started or stopped by receiving temperature information acquired by the temperature sensors (23, 24).

2. The cooling and heat radiating box of claim 1, wherein the first temperature sensor (23) is used for acquiring the temperature of the heating elements in real time, and transmitting acquired first temperature to the control unit (26); the control unit (26) is configured to compare the first temperature with a first threshold, and when the first temperature is equal to or greater than the first threshold, the control unit (26) controls the first blower (4) to be started to initiate ventilation and heat radiation in the first air passage chamber (1), so that the heating elements are cooled through the first heat radiating fin (20);
and the second temperature sensor (24) is used for acquiring the air temperature of the inner chamber (2) in real time, and transmitting acquired second temperature to the control unit (26); and the control unit (26) is configured to compare the second temperature with a second threshold, and when the second temperature is equal to or greater than the second threshold, the control unit (26) controls the second blower (15) to be started to initiate air circulation in the inner chamber (2).

3. The cooling and heat radiating box of claim 1, wherein the first blower (4) is a multi-position blower;
the first temperature sensor (23) is used for acquiring the temperature of the heating elements in real time, and transmitting acquired first temperature to the control unit (26); the control unit (26) is configured to compare the first temperature with a first threshold, and when the first temperature is equal to or greater than the first threshold, the control unit (26) controls the first blower (4) to be started to initiate ventilation and heat radiation in the first air passage chamber (1), so that the heating elements are cooled through the first heat radiating fin (20);
when the first temperature, acquired by the first temperature sensor (23), of the heating elements is equal to or greater than a third threshold, the control unit (26) is configured to control the first blower (4) to rise position and increase air flow rate in the first air passage chamber (1), thereby accelerating thermal exchange, wherein the third threshold is greater than the first threshold.

4. The cooling and heat radiating box of claim 2, wherein the first blower (4) is a multi-position blower; when the first temperature, acquired by the first temperature sensor (23), of the heating elements is equal to or greater than a third threshold, the control unit (26) is configured to control the first blower (4) to rise position and increase air flow rate in the first air passage chamber (1), thereby accelerating thermal exchange, wherein the third threshold is greater than the first threshold.

5. The cooling and heat radiating box of claim 2, wherein a second air passage chamber (10) is disposed between the first air passage chamber (1) and the first blower chamber (5); the first air passage chamber (1) communicates to the second air passage chamber (10) through a second ventilating opening (12), and the second air passage chamber (10) communicates to the first blower chamber (5) through a third ventilating opening (14); and the air inlet (3), the first air passage chamber (1), the second air passage chamber (10), the first blower chamber (5) and the air outlet (6) sequentially form the first ventilating path (9).

6. The cooling and heat radiating box of claim 3, wherein a second air passage chamber (10) is disposed between the first air passage chamber (1) and the first blower chamber (5); the first air passage chamber (1) communicates to the second air passage chamber (10) through a second ventilating opening (12), and the second air passage chamber (10) communicates to the first blower chamber (5) through a third ventilating opening (14); and the air inlet (3), the first air passage chamber (1), the second air passage chamber (10), the first blower chamber (5) and the air outlet (6) sequentially form the first ventilating path (9).

7. The cooling and heat radiating box of claim 4, wherein a second air passage chamber (10) is disposed between the first air passage chamber (1) and the first blower chamber (5); the first air passage chamber (1) communicates to the second air passage chamber (10) through a second ventilating opening (12), and the second air passage chamber (10) communicates to the first blower chamber (5) through a third ventilating opening (14); and the air inlet (3), the first air passage chamber (1), the second air passage chamber (10), the first blower chamber (5) and the air outlet (6) sequentially form the first ventilating path (9).

8. The cooling and heat radiating box of any one of claims 1-7, wherein a fourth partition plate (17) is disposed in the inner chamber (2) and is provided with a fourth ventilating opening (18), and the second blower (15) is disposed at the fourth ventilating opening (18) and is used for transporting air at one side of the fourth partition plate (17) to another side, thereby realizing air circulation in the inner chamber (2).

9. The cooling and heat radiating box of any one of claims 1-8, the second heat radiating fin (22) is a bidirectional heat radiating fin, a first fin group (2201) at a first side of the second heat radiating fin (22) is exposed in the first air passage chamber (1), and a second fin group (2202) at a second side of the second heat radiating fin (22) is exposed in the cavity region (202).

10. The cooling and heat radiating box of claim 9, wherein fins of the first fin group (2201) are gradually raised along an air flowing direction; the first heat radiating fin (20) and the first fin group (2201) which are exposed in the first air passage chamber (1) are disposed in a direction the same as an air flowing direction in the first air passage chamber (1); and the second fin group (2202) of the second heat radiating fin exposed in the inner chamber is disposed in a direction the same as an air flowing direction in the inner chamber (2).

11. The cooling and heat radiating box of any one of claims 1-10, wherein the element regions (201) are symmetrically disposed.

12. The cooling and heat radiating box of any one of claims 1-11, wherein a mounting position of the element regions (201) in the inner chamber is close to the air inlet (3).

13. The cooling and heat radiating box of any one of claims 1-12, wherein a wiring chamber (25) can also be disposed in the box, and the wiring chamber (25) is respectively adjacent to the inner chamber (2) and the second air passage chamber (10).

14. A heat radiating control method for a cooling and heat radiating box of a charger used in a high-speed train, implemented on the cooling and heat radiating box of any one of claims 1-13, comprising the following steps:
acquiring, by the first temperature sensor, the temperature of the heating elements in real time, and transmitting acquired first temperature to the control unit; comparing, by the control unit, the first temperature with a first threshold, and when the first temperature is equal to or greater than the first threshold, controlling, by the control unit, the first blower to be started to initiate ventilation and heat radiation in the first air passage chamber, so that the heating elements are cooled; and
acquiring, by the second temperature sensor, the air temperature of the inner chamber in real time, and transmitting acquired second temperature to the control unit; comparing, by the control unit, the second temperature with a second threshold, and when the second temperature is equal to or greater than the second threshold, controlling, by the control unit, the second blower to be started to initiate air circulation in the inner chamber, thus radiate heat to the first air passage chamber through the second heat radiating fin.

15. The heat radiating control method of claim 14 further comprising: when the first temperature acquired by the first temperature sensor is equal to or greater than a third threshold, controlling, by the control unit, the first blower to rise position and increase the air flow rate in the first air passage chamber, thereby accelerating thermal exchange, wherein the third threshold is greater than the first threshold.

## Patentansprüche

1. Kühlende und wärmeabstrahlende Box eines Ladegeräts, das in einem Hochgeschwindigkeitszug verwendet wird, wobei die kühlende und wärmeabstrahlende Box eine erste Luftdurchgangskammer (1) und eine innere Kammer (2) umfasst, die die erste Luftdurchgangskammer umgibt;
wobei ein erstes Ende (101) der ersten Luftdurchgangskammer mit einem Lufteinlass (3) verbunden ist, ein zweites Ende (102) der ersten Luftdurchgangskammer mit einer ersten Gebläsekammer (5) kommuniziert und ein erstes Gebläse (4) in der ersten Gebläsekammer (5) angeordnet ist; wobei die erste Gebläsekammer (5) mit einem Luftauslass (6) bereitgestellt ist; und der Lufteinlass (3), die erste Luftdurchgangskammer (1), die erste Gebläsekammer (5) und der Luftauslass (6) nacheinander einen ersten Lüftungsweg (9) bilden, um einen Luftstrom in der ersten Luftdurchgangskammer zu verwirklichen;
wobei die innere Kammer (2) Elementbereiche (201) und einen Hohlraumbereich (202) umfasst, und Wärmeelemente in den Elementbereichen (201) angeordnet sind, wobei jede von zwei Seiten der ersten Luftdurchgangskammer (1) jeweils mit einem der Elementbereiche (201) bereitgestellt ist;
wobei der Hohlraumbereich (202) die Elementbereiche (201) umfasst, der Hohlraumbereich (202) die gesamte erste Luftdurchgangskammer (1) umgibt;
wobei ein zweites Gebläse (15) in der inneren Kammer (2) angeordnet ist und genutzt wird, um zu ermöglichen, dass Luft in der inneren Kammer strömt, um einen zweiten Lüftungsweg (16) zu bilden;
wobei eine erste wärmeabstrahlende Rippe (20) zwischen jedem der Elementbereiche (201) und der ersten Luftdurchgangskammer (1) angeordnet ist, und die erste wärmeableitende Rippe (20) in der ersten Luftdurchgangskammer (1) freigelegt ist;
wobei eine zweite wärmeabstrahlende Rippe (22) zwischen dem Hohlraumbereich (202) und der ersten Luftdurchgangskammer (1) angeordnet ist, und die zweite wärmeabstrahlende Rippe (22) in der ersten Luftdurchgangskammer (1) freigelegt ist; wobei die zweite wärmeabstrahlende Rippe (22) sowohl auf einer Oberseite als auch einer Unterseite der ersten Luftdurchgangskammer (1) bereitgestellt ist;
wobei sowohl die erste wärmeabstrahlende Rippe (20) und die zweite wärmeabstrahlende Rippe (22) auf gegenüberliegenden Seiten der ersten Durchgangskammer (1) bereitgestellt sind;
wobei ein erster Temperatursensor (23), der in der Lage ist, Temperatur der Wärmeelemente zu erfassen, und ein zweiter Temperatursensor (24), der in der Lage ist, Lufttemperatur der inneren Kammer zu erfassen, in der inneren Kammer (2) angeordnet sind;
wobei die Box ferner mit einer Steuereinheit (26) ausgestattet ist und die Steuereinheit (26) mit dem ersten Gebläse (4), dem zweiten Gebläse (15), dem ersten Temperatursensor (23) und dem zweiten Temperatursensor (24) elektrisch verbunden ist; und die Steuereinheit (26) zum Steuern des ersten Gebläses (4) und des zweiten Gebläses (15) verwendet wird, sodass diese gestartet oder angehalten werden, indem sie Temperaturinformationen empfängt, die durch die Temperatursensoren (23, 24) erworben werden.

2. Kühlende und wärmeabstrahlende Box nach Anspruch 1, wobei der erste Temperatursensor (23) zum Erwerben der Temperatur der Wärmeelemente in Echtzeit und Übertragen der erworbenen ersten Temperatur an die Steuereinheit (26) verwendet wird; die Steuereinheit (26) konfiguriert ist, um die erste Temperatur mit einem ersten Schwellenwert zu vergleichen, und wenn die erste Temperatur gleich wie oder größer als der erste Schwellenwert ist, die Steuereinheit (26) das erste Gebläse (4) steuert, sodass es gestartet wird, um die Lüftung und Wärmeabstrahlung in der ersten Luftdurchgangskammer (1) zu initiieren, sodass die Wärmeelemente durch die erste wärmeabstrahlende Rippe (20) gekühlt werden;
und der zweite Temperatursensor (24) zum Erwerben der Lufttemperatur der inneren Kammer (2) in Echtzeit und Übertragen der erworbenen zweiten Temperatur an die Steuereinheit (26) verwendet wird; und die Steuereinheit (26) konfiguriert ist, um die zweite Temperatur mit einem zweiten Schwellenwert zu vergleichen, und wenn die zweite Temperatur gleich wie oder größer als der zweite Schwellenwert ist, die Steuereinheit (26) das zweite Gebläse (15) steuert, sodass es gestartet wird, um die Luftzirkulation in der inneren Kammer (2) zu initiieren.

3. Kühlende und wärmeabstrahlende Box nach Anspruch 1, wobei das erste Gebläse (4) ein Multipositionsgebläse ist;
wobei der erste Temperatursensor (23) zum Erwerben der Temperatur der Wärmeelemente in Echtzeit und Übertragen der erworbenen ersten Temperatur an die Steuereinheit (26) verwendet wird; die Steuereinheit (26) konfiguriert ist, um die erste Temperatur mit einem ersten Schwellenwert zu vergleichen, und wenn die erste Temperatur gleich wie oder größer als der erste Schwellenwert ist, die Steuereinheit (26) das erste Gebläse (4) steuert, sodass es gestartet wird, um die Lüftung und Wärmeabstrahlung in der ersten Luftdurchgangskammer (1) zu initiieren, sodass die Wärmeelemente durch die erste wärmeabstrahlende Rippe (20) gekühlt werden;
wenn die erste Temperatur, erworben durch den ersten Temperatursensor (23), der Wärmeelemente gleich wie oder größer als ein dritter Schwellenwert ist, die Steuereinheit (26) konfiguriert ist, um das erste Gebläse (4) zu steuern, um die Position anzuheben und den Luftdurchsatz in der ersten Luftdurchgangskammer (1) zu erhöhen, wodurch der Wärmeaustausch beschleunigt wird, wobei der dritte Schwellenwert größer als der erste Schwellenwert ist.

4. Kühlende und wärmeabstrahlende Box nach Anspruch 2, wobei das erste Gebläse (4) ein Multipositionsgebläse ist; wenn die erste Temperatur, erworben durch den ersten Temperatursensor (23), der Wärmeelemente gleich wie oder größer als ein dritter Schwellenwert ist, die Steuereinheit (26) konfiguriert ist, um das erste Gebläse (4) zu steuern, um die Position anzuheben und den Luftdurchsatz in der ersten Luftdurchgangskammer (1) zu erhöhen, wodurch der Wärmeaustausch beschleunigt wird, wobei der dritte Schwellenwert größer als der erste Schwellenwert ist.

5. Kühlende und wärmeabstrahlende Box nach Anspruch 2, wobei eine zweite Luftdurchgangskammer (10) zwischen der ersten Luftdurchgangskammer (1) und der ersten Gebläsekammer (5) angeordnet ist; wobei die erste Luftdurchgangskammer (1) mit der zweiten Luftdurchgangskammer (10) durch eine zweite Lüftungsöffnung (12) kommuniziert und die zweite Luftdurchgangskammer (10) mit der ersten Gebläsekammer (5) durch eine dritte Lüftungsöffnung (14) kommuniziert; und der Lufteinlass (3), die erste Luftdurchgangskammer (1), die zweite Luftdurchgangskammer (10), die erste Gebläsekammer (5) und der Luftauslass (6) nacheinander den ersten Lüftungsweg (9) bilden.

6. Kühlende und wärmeabstrahlende Box nach Anspruch 3, wobei eine zweite Luftdurchgangskammer (10) zwischen der ersten Luftdurchgangskammer (1) und der ersten Gebläsekammer (5) angeordnet ist; die erste Luftdurchgangskammer (1) mit der zweiten Luftdurchgangskammer (10) durch eine zweite Lüftungsöffnung (12) kommuniziert und die zweite Luftdurchgangskammer (10) mit der ersten Gebläsekammer (5) durch eine dritte Lüftungsöffnung (14) kommuniziert; und der Lufteinlass (3), die erste Luftdurchgangskammer (1), die zweite Luftdurchgangskammer (10), die erste Gebläsekammer (5) und der Luftauslass (6) nacheinander den ersten Lüftungsweg (9) bilden.

7. Kühlende und wärmeabstrahlende Box nach Anspruch 4, wobei eine zweite Luftdurchgangskammer (10) zwischen der ersten Luftdurchgangskammer (1) und der ersten Gebläsekammer (5) angeordnet ist; die erste Luftdurchgangskammer (1) mit der zweiten Luftdurchgangskammer (10) durch eine zweite Lüftungsöffnung (12) kommuniziert und die zweite Luftdurchgangskammer (10) mit der ersten Gebläsekammer (5) durch eine dritte Lüftungsöffnung (14) kommuniziert; und der Lufteinlass (3), die erste Luftdurchgangskammer (1), die zweite Luftdurchgangskammer (10), die erste Gebläsekammer (5) und der Luftauslass (6) nacheinander den ersten Lüftungsweg (9) bilden.

8. Kühlende und wärmeabstrahlende Box nach einem der Ansprüche 1-7, wobei eine vierte Trennwand (17) in der inneren Kammer (2) angeordnet ist und mit einer vierten Lüftungsöffnung (18) bereitgestellt ist, und das zweite Gebläse (15) an der vierten Lüftungsöffnung (18) angeordnet ist und zum Transport von Luft auf einer Seite der vierten Trennwand (17) auf eine andere Seite verwendet wird, wodurch eine Luftzirkulation in der inneren Kammer (2) verwirklicht wird.

9. Kühlende und wärmeabstrahlende Box nach einem der Ansprüche 1-8, wobei die zweite wärmeabstrahlende Rippe (22) eine bidirektionale wärmeabstrahlende Rippe ist, eine erste Rippengruppe (2201) auf einer ersten Seite der zweiten wärmeabstrahlenden Rippe (22) in der ersten Luftdurchgangskammer (1) freigelegt ist und eine zweite Rippengruppe (2202) auf einer zweiten Seite der zweiten wärmeabstrahlenden Rippe (22) in dem Hohlraumbereich (202) freigelegt ist.

10. Kühlende und wärmeabstrahlende Box nach Anspruch 9, wobei Rippen der ersten Rippengruppe (2201) entlang einer Luftstromrichtung allmählich angehoben werden; die erste wärmeabstrahlende Rippe (20) und die erste Rippengruppe (2201), die in der ersten Luftdurchgangskammer (1) freigelegt sind, in einer Richtung angeordnet sind, die die gleiche ist wie eine Luftstromrichtung in der ersten Luftdurchgangskammer (1); und die zweite Rippengruppe (2202) der zweiten wärmeabstrahlenden Rippe, die in der inneren Kammer freigelegt ist, in einer Richtung angeordnet ist, die die gleiche ist wie eine Luftstromrichtung in der inneren Kammer (2).

11. Kühlende und wärmeabstrahlende Box nach einem der Ansprüche 1-10, wobei die Elementbereiche (201) symmetrisch angeordnet sind.

12. Kühlende und wärmeabstrahlende Box nach einem der Ansprüche 1-11, wobei eine Montageposition der Elementbereiche (201) in der inneren Kammer nahe dem Lufteinlass (3) ist.

13. Kühlende und wärmeabstrahlende Box nach einem der Ansprüche 1-12, wobei eine Verdrahtungskammer (25) auch in der Box angeordnet sein kann und die Verdrahtungskammer (25) benachbart zu der inneren Kammer (2) bzw. der zweiten Luftdurchgangskammer (10) ist.

14. Wärmeabstrahlungs-Steuerverfahren für eine kühlende und wärmeabstrahlende Box eines Ladegeräts, das in einem Hochgeschwindigkeitszug verwendet wird, implementiert an der kühlenden und wärmeabstrahlenden Box nach einem der Ansprüche 1-13, umfassend die folgenden Schritte:
Erwerben, durch den ersten Temperatursensor, der Temperatur der Wärmeelemente in Echtzeit und Übertragen der erworbenen ersten Temperatur an die Steuereinheit; Vergleichen, durch die Steuereinheit, der ersten Temperatur mit einem ersten Schwellenwert, und wenn die erste Temperatur gleich wie oder größer als der erste Schwellenwert ist, Steuern, durch die Steuereinheit, des ersten Gebläses, sodass es gestartet wird, um die Lüftung und Wärmeabstrahlung in der ersten Luftdurchgangskammer zu initiieren, sodass die Wärmeelemente gekühlt werden; und
Erwerben, durch den zweiten Temperatursensor, der Lufttemperatur der inneren Kammer in Echtzeit und Übertragen der erworbenen zweiten Temperatur an die Steuereinheit; Vergleichen, durch die Steuereinheit, der zweiten Temperatur mit einem zweiten Schwellenwert, und wenn die zweite Temperatur gleich wie oder größer als der zweite Schwellenwert ist, Steuern, durch die Steuereinheit, des zweiten Gebläses, sodass es gestartet wird, um die Luftzirkulation in der inneren Kammer zu initiieren, wodurch Wärme zu der ersten Luftdurchgangskammer durch die zweite wärmeabstrahlende Rippe abgestrahlt wird.

15. Wärmeabstrahlungs-Steuerverfahren nach Anspruch 14, ferner umfassend:
wenn die erste Temperatur, erworben durch den ersten Temperatursensor, gleich wie oder größer als ein dritter Schwellenwert ist, Steuern, durch die Steuereinheit, des ersten Gebläses, um die Position anzuheben und den Luftdurchsatz in der ersten Luftdurchgangskammer zu erhöhen, wodurch der Wärmeaustausch beschleunigt wird, wobei der dritte Schwellenwert größer als der erste Schwellenwert ist.

## Revendications

1. Boîte de rayonnement de chaleur et de refroidissement d'un chargeur utilisé dans un train à grande vitesse, la boîte de rayonnement de chaleur et de refroidissement comprenant une première chambre de passage d'air (1) et une chambre intérieure (2) entourant la première chambre de passage d'air ;
une première extrémité (101) de la première chambre de passage d'air est raccordée à une entrée d'air (3), une seconde extrémité (102) de la première chambre de passage d'air communique avec une chambre de première soufflante (5), et une première soufflante (4) est disposée à l'intérieur de la chambre de première soufflante (5) ; la chambre de première soufflante (5) est pourvue d'une sortie d'air (6) ; et l'entrée d'air (3), la première chambre de passage d'air (1), la chambre de première soufflante (5) et la sortie d'air (6) forment séquentiellement un premier chemin de ventilation (9) pour réaliser un écoulement d'air dans la première chambre de passage d'air ;
la chambre intérieure (2) comprend des régions d'éléments (201) et une région de cavité (202), et des éléments chauffants sont disposés dans les régions d'éléments (201), dans laquelle
chacun de deux côtés de la première chambre de passage d'air (1) est pourvu d'une des régions d'éléments (201) respectivement ; la région de cavité (202) comprend les régions d'éléments (201), la région de cavité (202) entoure la première chambre de passage d'air entière (1) ;
une seconde soufflante (15) est disposée dans la chambre intérieure (2) et est utilisée pour permettre à de l'air dans la chambre intérieure de s'écouler pour former un second chemin de ventilation (16) ;
une première ailette de rayonnement de chaleur (20) est disposée entre chacune des régions d'éléments (201) et la première chambre de passage d'air (1), et la première ailette de rayonnement de chaleur (20) est exposée dans la première chambre de passage d'air (1) ;
une seconde ailette de rayonnement de chaleur (22) est disposée entre la région de cavité (202) et la première chambre de passage d'air (1), et la seconde ailette de rayonnement de chaleur (22) est exposée dans la première chambre de passage d'air (1) ; la seconde ailette de rayonnement de chaleur (22) est prévue à la fois sur un côté supérieur et sur un côté inférieur de la première chambre de passage d'air (1) ;
la première ailette de rayonnement de chaleur (20) et la seconde ailette de rayonnement de chaleur (22) sont toutes les deux prévues sur des côtés opposés de la première chambre de passage (1) ;
un premier capteur de température (23) capable de détecter une température des éléments chauffants et un second capteur de température (24) capable de détecter une température d'air de la chambre intérieure sont disposés dans la chambre intérieure (2) ;
la boîte est en outre pourvue d'une unité de commande (26), et l'unité de commande (26) est électriquement connectée à la première soufflante (4), la seconde soufflante (15), au premier capteur de température (23) et au second capteur de température (24) ; et l'unité de commande (26) est utilisée pour commander la première soufflante (4) et la seconde soufflante (15) pour être démarrées ou arrêtées en recevant des informations de température acquises par les capteurs de température (23, 24).

2. Boîte de rayonnement de chaleur et de refroidissement selon la revendication 1, dans laquelle le premier capteur de température (23) est utilisé pour acquérir la température des éléments chauffants en temps réel, et transmettre une première température acquise à l'unité de commande (26) ; l'unité de commande (26) est configurée pour comparer la première température à un premier seuil, et, lorsque la première température est égale ou supérieure au premier seuil, l'unité de commande (26) commande la première soufflante (4) pour être démarrée pour initialiser la ventilation et le rayonnement de chaleur dans la première chambre de passage d'air (1), pour que les éléments chauffants soient refroidis par le biais de la première ailette de rayonnement de chaleur (20) ;
et le second capteur de température (24) est utilisé pour acquérir la température d'air de la chambre intérieure (2) en temps réel, et transmettre une seconde température acquise à l'unité de commande (26) ; et l'unité de commande (26) est configurée pour comparer la seconde température à un deuxième seuil, et, lorsque la seconde température est égale ou supérieure au deuxième seuil, l'unité de commande (26) commande la seconde soufflante (15) pour être démarrée pour initialiser la circulation d'air dans la chambre intérieure (2).

3. Boîte de rayonnement de chaleur et de refroidissement selon la revendication 1, dans laquelle la première soufflante (4) est une soufflante à multi-position ;
le premier capteur de température (23) est utilisé pour acquérir la température des éléments chauffants en temps réel, et transmettre une première température acquise à l'unité de commande (26) ; l'unité de commande (26) est configurée pour comparer la première température à un premier seuil, et, lorsque la première température est égale ou supérieure au premier seuil, l'unité de commande (26) commande la première soufflante (4) pour être démarrée pour initialiser la ventilation et le rayonnement de chaleur dans la première chambre de passage d'air (1), pour que les éléments chauffants soient refroidis par le biais de la première ailette de rayonnement de chaleur (20) ;
lorsque la première température, acquise par le premier capteur de température (23), des éléments chauffants est égale ou supérieure à un troisième seuil, l'unité de commande (26) est configurée pour commander la première soufflante (4) pour hausser la position et augmenter la vitesse d'écoulement d'air dans la première chambre de passage d'air (1), ainsi accélérant l'échange thermique, dans laquelle le troisième seuil est supérieur au premier seuil.

4. Boîte de rayonnement de chaleur et de refroidissement selon la revendication 2, dans laquelle la première soufflante (4) est une soufflante à multi-position ; lorsque la première température, acquise par le premier capteur de température (23), des éléments chauffants est égale ou supérieure à un troisième seuil, l'unité de commande (26) est configurée pour commander la première soufflante (4) pour hausser la position et augmenter la vitesse d'écoulement d'air dans la première chambre de passage d'air (1), ainsi accélérant l'échange thermique, dans laquelle le troisième seuil est supérieur au premier seuil.

5. Boîte de rayonnement de chaleur et de refroidissement selon la revendication 2, dans laquelle un seconde chambre de passage d'air (10) est disposée entre la première chambre de passage d'air (1) et la chambre de première soufflante (5) ; la première chambre de passage d'air (1) communique avec la seconde chambre de passage d'air (10) par le biais d'une deuxième ouverture de ventilation (12), et la seconde chambre de passage d'air (10) communique avec la chambre de première soufflante (5) par le biais d'une troisième ouverture de ventilation (14) ; et l'entrée d'air (3), la première chambre de passage d'air (1), la seconde chambre de passage d'air (10), la chambre de première soufflante (5) et la sortie d'air (6) forment séquentiellement le premier chemin de ventilation (9).

6. Boîte de rayonnement de chaleur et de refroidissement selon la revendication 3, dans laquelle une seconde chambre de passage d'air (10) est disposée entre la première chambre de passage d'air (1) et la chambre de première soufflante (5) ; la première chambre de passage d'air (1) communique avec la seconde chambre de passage d'air (10) par le biais d'une deuxième ouverture de ventilation (12), et la seconde chambre de passage d'air (10) communique avec la chambre de première soufflante (5) par le biais d'une troisième ouverture de ventilation (14) ; et l'entrée d'air (3), la première chambre de passage d'air (1), la seconde chambre de passage d'air (10), la chambre de première soufflante (5) et la sortie d'air (6) forment séquentiellement le premier chemin de ventilation (9).

7. Boîte de rayonnement de chaleur et de refroidissement selon la revendication 4, dans laquelle une seconde chambre de passage d'air (10) est disposée entre la première chambre de passage d'air (1) et la chambre de première soufflante (5) ; la première chambre de passage d'air (1) communique avec la seconde chambre de passage d'air (10) par le biais d'une deuxième ouverture de ventilation (12), et la seconde chambre de passage d'air (10) communique avec la chambre de première soufflante (5) par le biais d'une troisième ouverture de ventilation (14) ; et l'entrée d'air (3), la première chambre de passage d'air (1), la seconde chambre de passage d'air (10), la chambre de première soufflante (5) et la sortie d'air (6) forment séquentiellement le premier chemin de ventilation (9).

8. Boîte de rayonnement de chaleur et de refroidissement selon l'une quelconque des revendications 1 à 7, dans laquelle une quatrième plaque de séparation (17) est disposée dans la chambre intérieure (2) et est pourvue d'une quatrième ouverture de ventilation (18), et la seconde soufflante (15) est disposée au niveau de la quatrième ouverture de ventilation (18) et est utilisée pour transporter de l'air sur un côté de la quatrième plaque de séparation (17) vers un autre côté, ainsi réalisant une circulation d'air dans la chambre intérieure (2).

9. Boîte de rayonnement de chaleur et de refroidissement selon l'une quelconque des revendications 1 à 8, la seconde ailette de rayonnement de chaleur (22) est une ailette de rayonnement de chaleur bidirectionnelle, un premier groupe d'ailettes (2201) sur un premier côté de la seconde ailette de rayonnement de chaleur (22) est exposé dans la première chambre de passage d'air (1), et un second groupe d'ailettes (2202) sur un second côté de la seconde ailette de rayonnement de chaleur (22) est exposé dans la région de cavité (202).

10. Boîte de rayonnement de chaleur et de refroidissement selon la revendication 9, dans laquelle des ailettes du premier groupe d'ailettes (2201) sont progressivement levées le long d'une direction d'écoulement d'air ; la première ailette de rayonnement de chaleur (20) et le premier groupe d'ailettes (2201) qui sont exposés dans la première chambre de passage d'air (1) sont disposés dans une direction identique à une direction d'écoulement d'air dans la première chambre de passage d'air (1) ; et le second groupe d'ailettes (2202), de la seconde ailette de rayonnement de chaleur, exposé dans la chambre intérieure est disposé dans une direction identique à une direction d'écoulement d'air dans la chambre intérieure (2).

11. Boîte de rayonnement de chaleur et de refroidissement selon l'une quelconque des revendications 1 à 10, dans laquelle les régions d'éléments (201) sont symétriquement disposées.

12. Boîte de rayonnement de chaleur et de refroidissement selon l'une quelconque des revendications 1 à 11, dans laquelle une position de montage des régions d'éléments (201) dans la chambre intérieure est près de l'entrée d'air (3).

13. Boîte de rayonnement de chaleur et de refroidissement selon l'une quelconque des revendications 1 à 12, dans laquelle une chambre de câblage (25) peut également être disposée dans la boîte, et la chambre de câblage (25) est respectivement adjacente à la chambre intérieure (2) et la seconde chambre de passage d'air (10).

14. Procédé de commande de rayonnement de chaleur pour une boîte de rayonnement de chaleur et de refroidissement d'un chargeur utilisé dans un train à grande vitesse, mis en œuvre sur la boîte de rayonnement de chaleur et de refroidissement selon l'une quelconque des revendications 1 à 13, comprenant les étapes suivantes :
l'acquisition, par le premier capteur de température, de la température des éléments chauffants en temps réel, et la transmission d'une première température acquise à l'unité de commande ; la comparaison, par l'unité de commande, de la première température à un premier seuil, et, lorsque la première température est égale ou supérieure au premier seuil, la commande, par l'unité de commande, de la première soufflante pour être démarrée pour initialiser la ventilation et le rayonnement de chaleur dans la première chambre de passage d'air, pour que les éléments chauffants soient refroidis ; et
l'acquisition, par le second capteur de température, de la température d'air de la chambre intérieure en temps réel, et la transmission d'une seconde température acquise à l'unité de commande ; la comparaison, par l'unité de commande, de la seconde température à un deuxième seuil, et, lorsque la seconde température est égale ou supérieure au deuxième seuil, la commande, par l'unité de commande, de la seconde soufflante pour être démarrée pour initialiser la circulation d'air dans la chambre intérieure, ainsi faire rayonner de la chaleur vers la première chambre de passage d'air par le biais de la seconde ailette de rayonnement de chaleur.

15. Procédé de commande de rayonnement de chaleur selon la revendication 14, comprenant en outre :
lorsque la première température acquise par le premier capteur de température est égale ou supérieure à un troisième seuil, la commande, par l'unité de commande, de la première soufflante pour hausser la position et augmenter la vitesse d'écoulement d'air dans la première chambre de passage d'air, ainsi accélérant l'échange thermique, dans lequel le troisième seuil est supérieur au premier seuil.
